(19)

**Europäisches Patentamt**

**European Patent Office**

**Office européen des brevets**

(11)  **EP 4 246 160 B1**

(12)  **EUROPEAN PATENT SPECIFICATION**

(45) Date of publication and mention
of the grant of the patent:
**10.12.2025  Bulletin 2025/50**

(21) Application number: **22853340.2**

(22) Date of filing: **27.07.2022**

(51) International Patent Classification (IPC):
*G01R 31/374* $^{(2019.01)}$     *G01R 31/382* $^{(2019.01)}$
*G01R 31/389* $^{(2019.01)}$     *G01R 19/165* $^{(2006.01)}$
*G01R 19/10* $^{(2006.01)}$      *G01R 27/08* $^{(2006.01)}$
*H01M 10/48* $^{(2006.01)}$      *H01M 10/42* $^{(2006.01)}$
*G01R 31/3835* $^{(2019.01)}$    *G01R 31/396* $^{(2019.01)}$

(52) Cooperative Patent Classification (CPC):
**G01R 31/389; G01R 19/16542; G01R 31/3835;
G01R 31/396; H01M 10/425; H01M 10/482;**
H01M 2010/4271; Y02E 60/10

(86) International application number:
**PCT/KR2022/011056**

(87) International publication number:
**WO 2023/013962 (09.02.2023 Gazette 2023/06)**

(54) **BATTERY MANAGEMENT DEVICE AND METHOD**

BATTERIEVERWALTUNGSVORRICHTUNG UND -VERFAHREN

DISPOSITIF ET PROCÉDÉ DE GESTION DE BATTERIE

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**

(30) Priority: **03.08.2021  KR 20210102179**

(43) Date of publication of application:
**20.09.2023  Bulletin 2023/38**

(73) Proprietor: **LG Energy Solution, Ltd.
Seoul 07335 (KR)**

(72) Inventors:
• **HAM, Seok Hyeong
Daejeon 34122 (KR)**
• **KIM, Duk You
Daejeon 34122 (KR)**

(74) Representative: **Goddar, Heinz J.
Boehmert & Boehmert
Anwaltspartnerschaft mbB
Pettenkoferstrasse 22
80336 München (DE)**

(56) References cited:

| | |
|---|---|
| EP-A1- 3 517 350 | WO-A1-2020/079978 |
| WO-A1-2020/204584 | WO-A1-2021/015501 |
| JP-A- 2012 186 985 | JP-A- 2012 186 985 |
| JP-A- 2020 063 983 | KR-A- 20130 053 501 |
| KR-A- 20190 011 568 | KR-B1- 101 927 123 |
| KR-B1- 101 927 123 | KR-B1- 102 256 602 |
| US-A1- 2014 312 913 | US-A1- 2016 178 684 |
| US-A1- 2016 377 685 | US-A1- 2019 260 097 |
| US-A1- 2019 356 143 | US-A1- 2019 361 075 |
| US-A1- 2020 064 408 | US-A1- 2020 124 678 |

Note: Within nine months of the publication of the mention of the grant of the European patent in the European Patent Bulletin, any person may give notice to the European Patent Office of opposition to that patent, in accordance with the Implementing Regulations. Notice of opposition shall not be deemed to have been filed until the opposition fee has been paid. (Art. 99(1) European Patent Convention).

**Description**

**[TECHNICAL FIELD]**

CROSS-REFERENCE TO RELATED APPLICATION

This application claims priority to and the benefit of Korean Patent Application No. 10-2021-0102179 filed in the Korean Intellectual Property Office on August 3, 2021.

TECHNICAL FIELD

The present invention relates to a battery management apparatus and method.

**[BACKGROUND ART]**

A secondary battery is generally used as a battery pack including a battery module where a plurality of battery cells are connected to one another in series and/or in parallel. Battery packs may be managed and controlled by a battery management system in terms of their states and operations.

Today, with an increasing demand for such secondary batteries, the importance of a battery management system (BMS) that manages a battery pack or a battery module is also increasing. Generally, the BMS essentially includes a Battery Monitoring Integrated Circuit BMIC circuit that measures a voltage and performs balancing between battery cells, etc.

A voltage of a battery cell may be simply measured by using the BMIC circuit, but a voltage error may occur for battery cells provided at opposite ends of a battery module due to a voltage drop caused by a current required for driving of the BMIC circuit and an internal resistance of a battery cell.

As such, since the voltages of the battery cells at the opposite ends of the battery module are measured lower than those of other battery cells, a separate voltage measuring apparatus is required to correct the error.

The prior art relevant to the present invention is given by US 2019/361075 A1, US 2019/356143 A1, KR 101 927 123 B1 and US 2020/124678 A1. It is known from the prior art a master battery management unit including a sensing unit generating pack information of the battery pack, a first master power supply unit generating a first operating voltage using voltage of the battery pack, a communication unit outputting a first switching signal in response to the first operating voltage supplied from the first master power supply unit, a second master power supply unit generating a second operating voltage using the pack voltage in response to the first switching signal, and a control unit operating using the second operating voltage supplied from the second master power supply unit, and testing a preset item based on at least one of the pack information and module information.

**[DISCLOSURE]**

**[TECHNICAL PROBLEM]**

The present invention aims to provide a battery management apparatus and method in which an error caused by an internal resistance may be automatically corrected without a separate apparatus in voltage measurement for a battery cell.

Technical problems of the embodiments disclosed herein are not limited to the above-described technical problems, and other unmentioned technical problems would be clearly understood by one of ordinary skill in the art from the following description.

**[TECHNICAL SOLUTION]**

The invention is directed to an apparatus according to claim 1, which includes a power source unit including a plurality of power sources, a measurement unit configured to measure a first voltage by applying a first power source among the plurality of power sources to a battery cell and to measure a second voltage by applying a second power source among the plurality of power sources to the battery cell, and a calculating unit configured to calculate a voltage of the battery cell based on the first voltage and the second voltage.

The calculating unit is configured to calculate the voltage of the battery cell based on a difference between the first voltage and the second voltage.

The calculating unit is further configured to calculate an internal resistance of the battery cell based on the first voltage and the second voltage.

The calculating unit is further configured to correct the voltage of the battery cell based on the internal resistance of the battery cell.

According to an embodiment, the battery cell may be a battery cell provided in one end of a battery module.

According to an embodiment, the plurality of power sources may be driving power sources of a BMIC circuit that manages the battery cell.

The present invention is also directed to a battery management method according to claim 4, which includes measuring a first voltage by applying a first power source among a plurality of power sources to a battery cell, measuring a second voltage by applying a second power source, which is different from the first power source, among the plurality of power sources, to the battery cell, and calculating a voltage of the battery cell based on the first voltage and the second voltage.

The calculating of the voltage of the battery cell includes calculating the voltage of the battery cell based on a difference between the first voltage and the second voltage.

the calculating of the voltage of the battery cell includes calculating an internal resistance of the battery cell based on the first voltage and the second voltage.

The calculating of the voltage of the battery cell includes correcting the voltage of the battery cell based on the internal resistance of the battery cell.

## [ADVANTAGEOUS EFFECTS]

A battery management apparatus and method according to an embodiment disclosed herein may automatically correct an error caused by an internal resistance without a separate apparatus in voltage measurement for a battery cell.

## [DESCRIPTION OF DRAWINGS]

FIG. 1 schematically illustrates a configuration of a battery control system including a battery management apparatus according to an embodiment disclosed herein.

FIG. 2 is a block diagram illustrating a structure of a battery management apparatus, according to an embodiment disclosed herein.

FIG. 3 is a view of conventional battery module and battery management apparatus.

FIG. 4 is a view of a battery module and a battery management apparatus according to an embodiment disclosed herein.

FIG. 5 is a flowchart illustrating a battery management method according to an embodiment disclosed herein.

FIG. 6 is a block diagram showing a hardware configuration of a computing system for performing a battery management method according to an embodiment disclosed herein.

## [MODE FOR INVENTION]

Hereinafter, various embodiments disclosed herein will be described in detail with reference to the accompanying drawings. In this document, identical reference numerals will be used for identical components in the drawings, and the identical components will not be redundantly described.

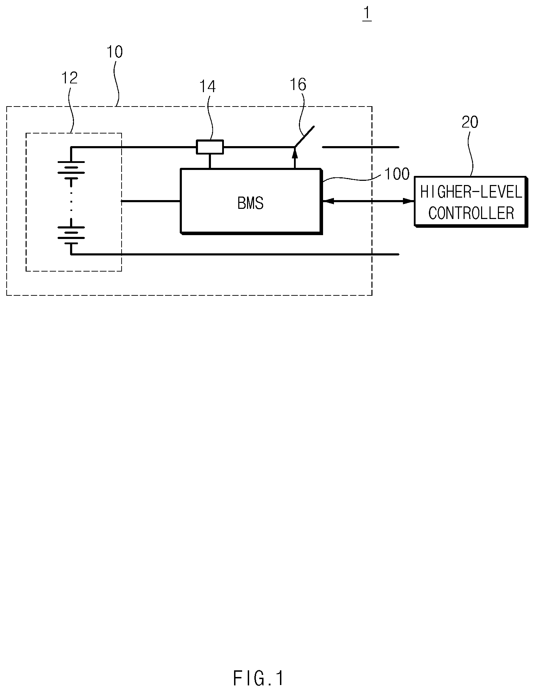

FIG. 1 schematically illustrates a configuration of a battery control system including a battery management apparatus according to an embodiment disclosed herein.

Referring to FIG. 1, a battery control system 1 may include a battery pack 10 and a higher-level controller 20. The battery pack 10 may include a battery module 12, a sensor 14, a switching unit 16, and a battery management apparatus (or a battery management system (BMS)) 100. The battery pack 10 may include the battery module 12, the sensor 14, the switching unit 16, and the battery management apparatus 100 provided in plural. The battery pack 10 may be connected in series or in parallel to communicate with the higher-level controller 20 provided outside.

The battery module 12 may include one or more chargeable/dischargeable battery cells. In this case, the battery module 12 may be connected in series or in parallel. The sensor 14 may detect current flowing in the battery pack 10. In this case, a detected signal **of current** may be transmitted to the battery management apparatus 100. The switching unit 16 may be connected in series to a (+) terminal side and a (-) terminal side of the battery module 12 to control the charging/discharging current flow of the battery module 12. For example, the switching unit 16 may use at least one switch, relay, magnetic contactor, etc., according to the specifications of the battery pack 10.

The battery management apparatus 100 may monitor the voltage, current, temperature, etc., of the battery pack 10 to perform control and management to prevent overcharging and over-discharging, etc., and may be, for example, a BMS of a battery pack.

The battery management apparatus 100, which is an interface for receiving measurement values of various parameter values, may include a plurality of terminals and a circuit, etc., connected to the terminals to process received values. The battery management apparatus 100 may control ON/OFF of the switching unit 16, e.g., a switch, a relay, a contactor, etc., and may be connected to the plurality of battery modules 12 to monitor the state of battery cells.

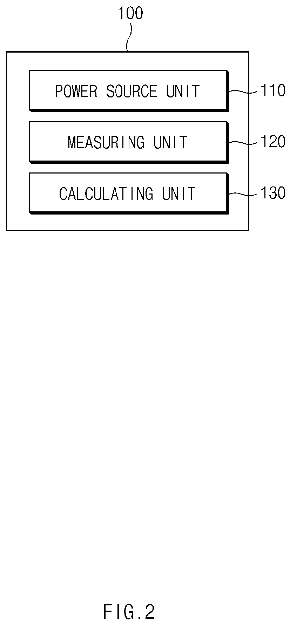

Meanwhile, the battery management apparatus 100 disclosed herein may measure a voltage of each battery cell included in the battery module 12 through a BMIC. The battery management apparatus 100 may measure a voltage of a battery cell by applying a plurality of BMIC driving currents and calculate an internal resistance of the battery cell based on the measured voltage. In this way, the battery management apparatus 100 may correct a voltage measurement error for a battery cell, caused by an internal resistance of the battery cell. The configuration of the battery management apparatus 100 will be described in detail with reference to FIG. 2.

The higher-level controller 20 may transmit various control signals regarding the battery module 12 to the battery management apparatus 100. Thus, the battery management apparatus 100 may also be controlled in terms of an operation thereof based on a signal applied from the higher-level controller 20. Meanwhile, the battery cell according to the present disclosure may be included in the battery module 12 used for an electric vehicle. However, the battery pack 10 of FIG. 1 is not limited to such a purpose, and for example, a battery rack of an energy storage system (ESS) may be included in place of the battery pack 10 of FIG. 1.

FIG. 2 is a block diagram illustrating a structure of a battery management apparatus, according to an embodiment disclosed herein.

Referring to FIG. 2, the battery management apparatus 100 according to an embodiment disclosed herein may include a power source unit 110, a measuring unit 120, and a calculating unit 130.

The power source unit 110 may include a plurality of power sources. In this case, the plurality of power sources included in the power source unit 110 may be driving power sources of a BMIC circuit that manages a battery cell. For example, the power source unit 110 may control the plurality of power sources through a switching circuit.

The measuring unit 120 may measure a voltage of a battery cell by applying a power source of the power source unit 110 to the battery cell. For example, the measuring unit 120 may measure a first voltage by applying a first power source among the plurality of power sources to the battery cell and measure a second voltage by applying a second power source among the plurality of power sources to the battery cell. The battery cell may be a battery cell provided in one end of a battery module.

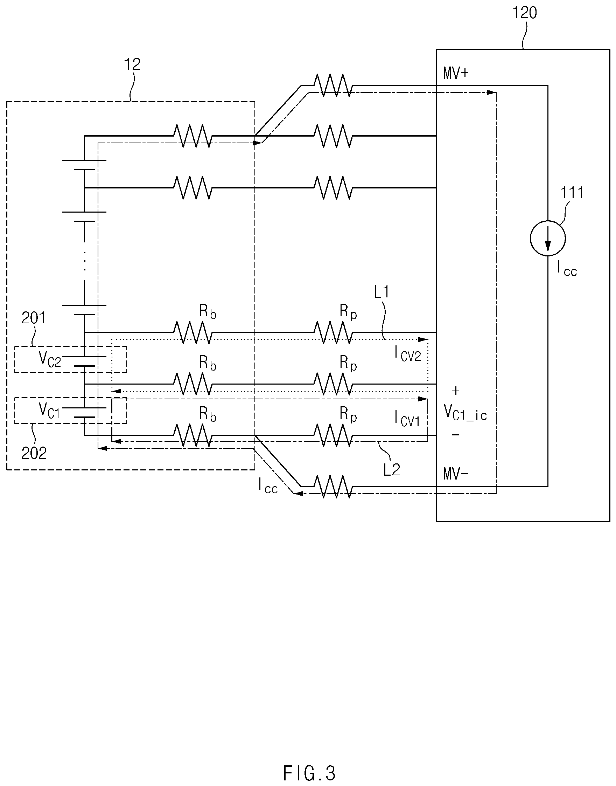

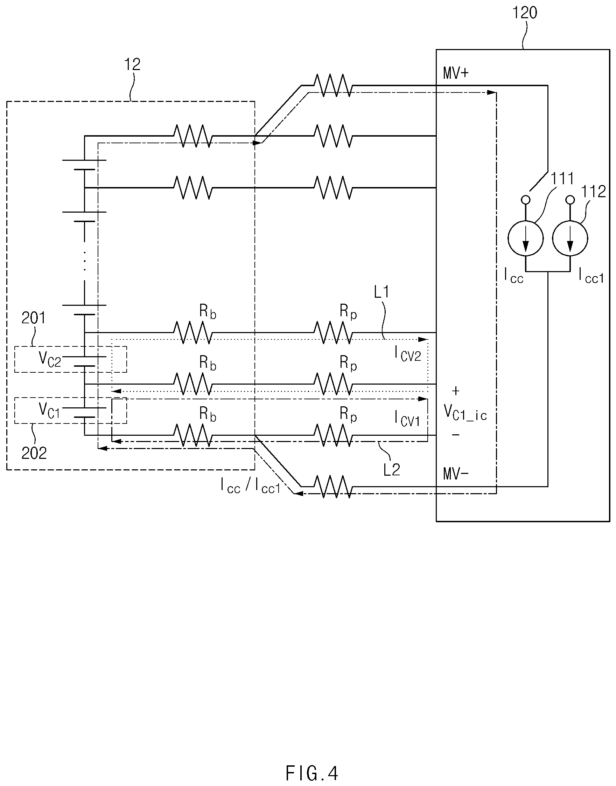

The calculating unit 130 may calculate a voltage of the battery cell based on the first voltage and the second voltage respectively measured by respectively applying the first power source and the second power source to the battery cell. For example, the calculating unit 130 may calculate the voltage of the battery cell based on a difference between the first voltage and the second voltage. In this case, the calculating unit 130 may calculate an internal resistance of the battery cell based on the first voltage and the second voltage measured for the battery cell. In this way, the calculating unit 130 may correct the voltage of the battery cell based on the internal resistance of the battery cell. A detailed voltage calculation method of the calculating unit 130 will be described with reference to FIGS. 3 and 4.

As such, the battery management apparatus 100 according to an embodiment disclosed herein may automatically correct an error caused by an internal resistance without a separate apparatus in voltage measurement for the battery cell.

FIG. 3 is a view of conventional battery module and battery management apparatus. FIG. 4 is a view of a battery module and a battery management apparatus according to an embodiment disclosed herein.

Referring to FIG. 3, in the conventional battery management apparatus, in voltage measurement for a battery cell 202 provided in one end of a battery module 12, a strong voltage drop occurs due to a driving current $I_{cc}$ of a BMIC supplied from a first power source 111 and an internal resistance $R_b$ of the battery cell 202. In this case, because of $I_{cc} \gg I_{CVn}$, the other battery cells are not affected by the voltage drop. Meanwhile, the internal resistance $R_b$ of the battery cell is difficult to directly measure.

As such, according to the conventional battery management apparatus, for the battery cell 202 provided in one end of the battery module 12, a voltage of the battery cell 202 is measured low at all times due to the internal resistance Rb of the battery cell 202, and correction thereof requires re-measurement using a separate voltage measurement apparatus.

Referring to FIG. 4, the battery management apparatus 100 according to an embodiment disclosed herein may be selectively supplied with a driving current of a BMIC from a first power source 111 and a second power source 112. That is, in the battery management apparatus 100 according to an embodiment disclosed herein, a BMIC driving current based on the first power source 111 may be applied and then a first voltage of the battery cell 202 may be measured through the measuring unit 120, and a BMIC driving current based on the second power source 112 may be applied and then a second voltage of the battery cell 202 may be measured through the measuring unit 120.

Moreover, the battery management apparatus 100 according to an embodiment disclosed herein may calculate the internal resistance $R_b$ of the battery cell based on a difference between the first voltage and the second voltage measured in this way. The battery management apparatus 100 may correct a voltage error of the battery cell 202 by using the calculated internal resistance Rb and driving currents $I_{cc}$ and $I_{cc1}$ of the BMIC. The other battery cells such as a battery cell 201 are not affected by a voltage drop caused by a driving current of the BMIC, not requiring separate correction.

More specifically, the calculating unit 130 of the battery management apparatus 100 according to an embodiment disclosed herein may calculate the voltage of the battery cell 202 according to the following equations. In this case, when a BMIC driving current $I_{cc}$ based on the first power source 111 is applied, the voltage of the battery cell 202 may be expressed according to the Kirchhoff's voltage law as below (L2).

[Equation 1]

$$V_{C1_{ic}} = V_{C1} - 2(R_b + R_p)I_{CV1} - R_b I_{cc} \approx V_{C1} - R_b I_{cc}$$

$$(I_{cc} \gg I_{CV1})$$

In addition, when a BMIC driving current $I_{cc1}$ based on the second power source 112 is applied, the voltage of the battery cell 202 may be expressed as below.

[Equation 2]

$$V_{C1_{ic1}} = V_{C1} - 2(R_b + R_p)I_{CV1} - R_b I_{cc1} \approx V_{C1} - R_b I_{cc1}$$

$$(I_{cc1} \gg I_{CV1})$$

$V_{cn}$: a voltage of a battery cell,

$V_{Cu\_ic}$: a voltage of a battery cell measured in a BMIC

$R_b$: an internal resistance of a battery cell

$R_p$: a resistance of a connection path between a BMIC and a battery cell

$I_{Cvn}$: a current flowing to a pin in measurement of a voltage of a battery cell

$I_{cc}$, $I_{cc1}$: a driving current of a BMIC

As such, the calculating unit 130 of the battery management apparatus 100 according to an embodiment disclosed herein may calculate the internal resistance $R_b$ of a battery cell and a voltage $V_{C1}$ of the battery cell by simultaneously calculating Equation 1 and Equation 2. That is, it is possible to correct the voltage $V_{cn\_ic}$ of the battery cell measured by using the driving currents $I_{cc}$ and $I_{cc1}$ of the BMIC and the calculated internal resistance $R_b$ of the battery cell.

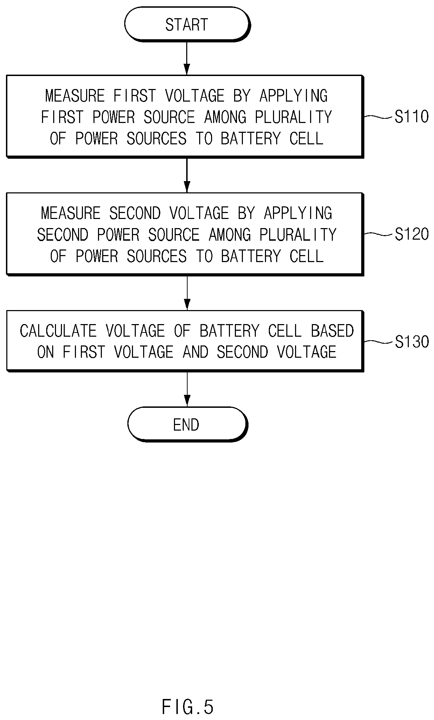

FIG. 5 is a flowchart illustrating a battery management method according to an embodiment disclosed herein.

Referring to FIG. 5, a battery management method according to an embodiment disclosed herein may measure a first voltage by applying a first power source among a plurality of power sources to a battery cell, in operation S110. A second voltage may be measured by applying a second power source among the plurality of power sources to the battery cell, in operation S120. The battery cell may be a battery cell provided in one end of a battery module. The plurality of power sources may be driving power sources of a BMIC circuit that manages the battery cell. For example, the plurality of power sources may be controlled through a switching circuit.

Next, the voltage of the battery cell may be calculated based on the first voltage and the second voltage, in operation S130. For example, the voltage of the battery cell may be calculated based on a difference between the first voltage and the second voltage. In this case, an internal resistance of the battery cell may be calculated based on the first voltage and the second voltage measured for the battery cell. In this way, in operation S130, the voltage of the battery cell may be corrected based on the internal resistance of the battery cell.

As such, the battery management method according to an embodiment disclosed herein may automatically correct an error caused by an internal resistance without a separate apparatus in voltage measurement for the battery cell.

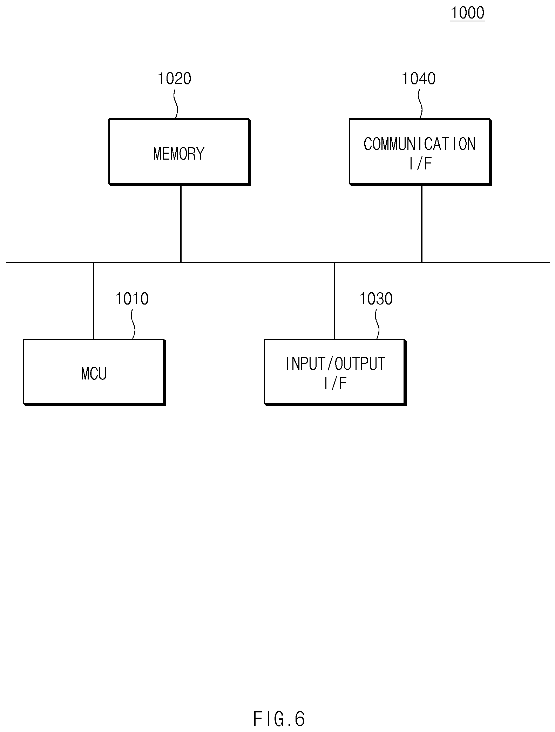

FIG. 6 is a block diagram showing a hardware configuration of a computing system for performing a battery management method according to an embodiment disclosed herein.

Referring to FIG. 6, a computing system 1000 according to an embodiment disclosed herein may include a Main Control Unit(MCU) 1010, a memory 1020, an input/output interface (I/F) 1030, and a communication I/F 1040.

The MCU 1010 may be a processor that executes various programs (e.g., a program for measuring a voltage of a battery, a program for calculating an internal resistance and a voltage of a battery cell, etc.) stored in the memory 1020, processes various data including voltage, internal resistance, etc., of a battery cell through these programs, and performs the above-described functions of the battery management apparatus 100 shown in FIG. 2.

The memory 1020 may store various programs regarding voltage measurement, internal resistance and voltage calculation, etc., for a battery cell. Moreover, the memory 1020 may store various data such as a voltage, an internal resistance, etc., of the battery cell.

The memory 1020 may be provided in plural, depending on a need. The memory 1020 may be volatile memory or non-volatile memory. For the memory 1020 as the volatile memory, random access memory (RAM), dynamic RAM (DRAM), static RAM (SRAM), etc., may be used. For the memory 1020 as the nonvolatile memory, read only memory (ROM), programmable ROM (PROM), electrically alterable ROM (EAROM), erasable PROM (EPROM), electrically erasable PROM (EEPROM), flash memory, etc., may be used. The above-listed examples of the memory 1020 are merely examples and are not limited thereto.

The input/output I/F 1030 may provide an interface for transmitting and receiving data by connecting an input device (not shown) such as a keyboard, a mouse, a touch panel, etc., and an output device such as a display (not shown), etc., to the MCU 1010.

The communication I/F 1040, which is a component capable of transmitting and receiving various data to and from a server, may be various devices capable of supporting wired or wireless communication. For example, a program for voltage measurement or internal resistance and voltage calculation for a battery cell, various data, etc., may be transmitted and received to and from a separately provided external server through the communication I/F 1040.

As such, a computer program according to an embodiment disclosed herein may be recorded in the memory 1020 and processed by the MCU 1010, thus being implemented as a module that performs functions shown in FIG. 2.

## Claims

1. A battery management apparatus (100) comprising:

   a power source unit (110) comprising a plurality of power sources;
   a measurement unit (120) configured to measure a first voltage by applying a first power source (111) among the plurality of power sources to a battery cell and to measure a second voltage by applying a second power source (112) different from the first power source (111) among the plurality of power sources to the battery cell; and
   a calculating unit (130) configured to calculate a voltage ($V_{cn}$) of the battery cell based on a difference between the first voltage and the second voltage,
   wherein the calculating unit (130) is further configured to calculate an internal resistance ($R_b$) of the battery cell based on the first voltage and the second voltage, and to correct the voltage ($V_{cn}$) of the battery cell based on the internal resistance ($R_b$) of the battery cell.

2. The battery management apparatus of claim 1, wherein the battery cell is a battery cell provided in one end of a battery module.

3. The battery management apparatus of claim 1, wherein the plurality of power sources are driving power sources of a BMIC circuit that manages the battery cell.

4. A battery management method comprising:

   measuring (S110) a first voltage by applying a first power source among a plurality of power sources to a battery cell;
   measuring (S120) a second voltage by applying a second power source, which is different from the first power source, among the plurality of power sources, to the battery cell; and
   calculating (S130) a voltage of the battery cell based on a difference between the first voltage and the second voltage,
   wherein the calculating (S130) of the voltage of the battery cell comprises calculating an internal resistance of the battery cell based on the first voltage and the second voltage, and correcting the voltage of the battery cell based on the internal resistance of the battery cell.

5. A battery management method of claim 4, wherein the battery cell is a battery cell (202) provided in one end of a battery module (12).

## Patentansprüche

1. Batteriemanagementvorrichtung (100) aufweisend:

eine Energiequelleneinheit (110), die mehrere Energiequellen aufweist;
eine Messeinheit (120), die konfiguriert ist, eine erste Spannung durch Anlegen einer ersten Energiequelle (111) von den mehreren Energiequellen an eine Batteriezelle zu messen und eine zweite Spannung durch Anlegen einer zweiten Energiequelle (112), die von der ersten Energiequelle (111) verschieden ist, von den mehreren Energiequellen an die Batteriezelle zu messen; und
eine Berechnungseinheit (130), die konfiguriert ist, eine Spannung ($V_{cn}$) der Batteriezelle basierend auf einer Differenz zwischen der ersten Spannung und der zweiten Spannung zu berechnen,
wobei die Berechnungseinheit (130) ferner konfiguriert ist, einen Innenwiderstand ($R_b$) der Batteriezelle basierend auf der ersten Spannung und der zweiten Spannung zu berechnen und die Spannung ($V_{cn}$) der Batteriezelle basierend auf dem Innenwiderstand ($R_b$) der Batteriezelle zu korrigieren.

2. Batteriemanagementvorrichtung nach Anspruch 1, wobei die Batteriezelle eine Batteriezelle ist, die in einem Ende eines Batteriemoduls bereitgestellt ist.

3. Batteriemanagementvorrichtung nach Anspruch 1, wobei die mehreren Energiequellen Antriebsenergiequellen einer BMIC-Schaltung sind, die die Batteriezelle managt.

4. Batteriemanagementverfahren umfassend:

Messen (S110) einer ersten Spannung durch Anlegen einer ersten Energiequelle von mehreren Energiequellen an eine Batteriezelle;
Messen (S120) einer zweiten Spannung durch Anlegen einer zweiten Energiequelle, die von der ersten Energiequelle verschieden ist, von den mehreren Energiequellen an die Batteriezelle; und
Berechnen (S130) einer Spannung der Batteriezelle basierend auf einer Differenz zwischen der ersten Spannung und der zweiten Spannung,
wobei das Berechnen (S130) der Spannung der Batteriezelle umfasst: Berechnen eines Innenwiderstands der Batteriezelle basierend auf der ersten Spannung und der zweiten Spannung und Korrigieren der Spannung der Batteriezelle basierend auf dem Innenwiderstand der Batteriezelle.

5. Batteriemanagementverfahren nach Anspruch 4, wobei die Batteriezelle eine Batteriezelle (202) ist, die in einem Ende eines Batteriemoduls (12) bereitgestellt ist.

**Revendications**

1. Appareil de gestion de batterie (100) comprenant :

un module de bloc d'alimentation (110) comprenant une pluralité de sources d'alimentation ;
un module de mesure (120) configuré pour mesurer une première tension en appliquant une première source d'alimentation (111), parmi la pluralité de sources d'alimentation, à une cellule de batterie, et mesurer une deuxième tension en appliquant une deuxième source d'alimentation (112) différente de la première source d'alimentation (111), parmi la pluralité de sources d'alimentation, à la cellule de batterie ; et
un dispositif de calcul (130) configuré pour calculer une tension ($V_{en}$) de la cellule de batterie d'après une différence entre la première tension et la deuxième tension,
le dispositif de calcul (130) étant configuré en outre pour calculer une résistance interne ($R_b$) de la cellule de batterie d'après la première tension et la deuxième tension, et rectifier la tension ($V_{en}$) de la cellule de batterie d'après la résistance interne ($R_b$) de la cellule de batterie.

2. Appareil de gestion de batterie selon la revendication 1, la cellule de batterie étant une cellule de batterie agencée dans un bout d'un module de batterie.

3. Appareil de gestion de batterie selon la revendication 1, la pluralité de sources d'alimentation étant des sources d'énergie d'excitation d'un circuit intégré de contrôle de batterie (BMIC) assurant la gestion de la cellule de batterie.

4. Procédé de gestion de batterie comprenant :

la mesure (S110) d'une première tension par l'application d'une première source d'alimentation, parmi une pluralité de sources d'alimentation, à une cellule de batterie ;

la mesure (S120) d'une deuxième tension par l'application d'une deuxième source d'alimentation, différente de la première source d'alimentation, parmi la pluralité de sources d'alimentation, à la cellule de batterie ; et

le calcul (S130) d'une tension de la cellule de batterie d'après une différence entre la première tension et la deuxième tension,

le calcul (S130) de la tension de la cellule de batterie comprenant le calcul d'une résistance interne de la cellule de batterie d'après la première tension et la deuxième tension, et la rectification de la tension de la cellule de batterie d'après la résistance interne de la cellule de batterie.

5. Procédé de gestion de batterie selon la revendication 4, la cellule de batterie étant une cellule de batterie (202) agencée à un bout d'un module de batterie (12).

FIG.1

100

```
+--------------------------------------+
|  +--------------------------------+  |
|  |      POWER SOURCE UNIT         |  |----110
|  +--------------------------------+  |
|  +--------------------------------+  |
|  |       MEASURING UNIT           |  |----120
|  +--------------------------------+  |
|  +--------------------------------+  |
|  |      CALCULATING UNIT          |  |----130
|  +--------------------------------+  |
+--------------------------------------+
```

FIG.2

FIG.3

FIG.4

```
                    ┌──────────────┐
                    │    START     │
                    └──────┬───────┘
                           │
                           ▼
        ┌──────────────────────────────────────┐
        │   MEASURE FIRST VOLTAGE BY APPLYING   │
        │   FIRST POWER SOURCE AMONG PLURALITY  │────S110
        │    OF POWER SOURCES TO BATTERY CELL   │
        └──────────────────┬───────────────────┘
                           │
                           ▼
        ┌──────────────────────────────────────┐
        │   MEASURE SECOND VOLTAGE BY APPLYING  │
        │  SECOND POWER SOURCE AMONG PLURALITY  │────S120
        │    OF POWER SOURCES TO BATTERY CELL   │
        └──────────────────┬───────────────────┘
                           │
                           ▼
        ┌──────────────────────────────────────┐
        │  CALCULATE VOLTAGE OF BATTERY CELL BASED │
        │   ON FIRST VOLTAGE AND SECOND VOLTAGE │────S130
        └──────────────────┬───────────────────┘
                           │
                           ▼
                    ┌──────────────┐
                    │     END      │
                    └──────────────┘
```

FIG.5

1000

1020

MEMORY

1040

COMMUNICATION
I/F

1010

MCU

1030

INPUT/OUTPUT
I/F

FIG.6

**EP 4 246 160 B1**

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- KR 1020210102179
- US 2019361075 A1
- US 2019356143 A1
- KR 101927123 B1
- US 2020124678 A1